Europäisches Patentamt

European Patent Office

Office européen des brevets

(19)

(11) Publication number: **0 196 152**
**A2**

(12) **EUROPEAN PATENT APPLICATION**

(21) Application number: **86300586.4**

(22) Date of filing: **29.01.86**

(51) Int. Cl.⁴: **G 06 F 11/26**

(30) Priority: **23.03.85 GB 8507613**

(43) Date of publication of application: **01.10.86**
**Bulletin 86/40**

(84) Designated Contracting States: **DE FR GB IT NL**

(71) Applicant: **INTERNATIONAL COMPUTERS LIMITED, ICL House, Putney, London, SW15 1SW (GB)**

(72) Inventor: **Hale, Stuart George, 101 Dane Road, Denton Manchester M34 2HY (GB)**
Inventor: **Naven, Finbar, 88 Crossefield Road, Cheadle Hulme Cheshire (GB)**

(74) Representative: **Guyatt, Derek Charles et al, STC Patents Edinburgh Way, Harlow Essex CM20 2SH (GB)**

(54) **Testing digital integrated circuits.**

(57) A digital integrated circuit includes a register (10) having a normal mode of operation in which it acts as a parallel input/output register. The register also has a second mode of operation in which it acts as a pseudo-random number generator, and a third mode in which it is connected as a circular shift register. This allows the register to be used for producing a variety of different test sequences for testing other parts of the circuits e.g. for testing a programmable logic array included in the circuit.

EP 0 196 152 A2

ACTORUM AG

## TESTING DIGITAL INTEGRATED CIRCUITS

This invention relates to testing digital integrated circuits.

One known technique for testing a digital integrated circuit is to provide a pseudo-random number generator integral with the circuit, for producing a sequence of test patterns for applying to the circuit. The pseudo-random number generator may be in the form of a shift register with one or more exclusive -OR gates forming feedback connections from selected stages of the register. The register may double as a normal parallel input/output register forming part of the normal data flow in the integrated circuit. One such arrangement is described, for example, in U.S. Patent No. 3961 252.

It has been found, however, that pseudo-random generators are not sufficient for testing certain types of circuit, such as programmable logic arrays (PLAs). Such generators either require very long test sequences, or else if a shortened sequence is used certain important test patterns may be omitted, and hence the circuit may not be tested fully.

An object of the invention is to overcome this problem.

### SUMMARY OF THE INVENTION

According to the invention, there is provided a digital integrated circuit including at least one register which is operable in a first mode in which it acts as a parallel input/output register, and in a second mode in which it acts as a pseudo-random number generator for producing test patterns for the circuit, characterised in that the register is also operable in a third mode in which it acts as a circular shift register for producing circularly shifting test patterns.

It is found that this extra mode, allowing circularly shifting test patterns to be produced, is extremely useful for testing certain types of circuits. For example, when testing a PLA, it can be used to apply a sliding "1" test pattern to the bit lines of the PLA, i.e. to apply a "1" to each bit line in turn, the other lines being held at zero. This allows each bit line to be selected in turn and greatly facilitates systematic checking of the PLA. Other sliding patterns, such as a sliding "0" pattern, are also useful.

The feedback connection for producing the circular shift may optionally include an inverter, so as to invert the sliding test pattern in alternate cycles through the register. This allows further useful sequences of test patterns to be produced.

One embodiment of the invention will now be described by way of example with reference to the accompanying drawings.

BRIEF DESCRIPTION OF THE DRAWINGS

Figure 1 is a block circuit diagram of a portion of a digital integrated circuit chip in accordance with the invention. Figure 2 is a circuit diagram of a register forming part of the chip.

Figure 3 is a logic diagram of a bit cell of the register.

Figure 4 is a logic diagram of a test bit cell associated with the register.

Figure 5 is a logic diagram of a control circuit associated with the register.

DETAILED DESCRIPTION

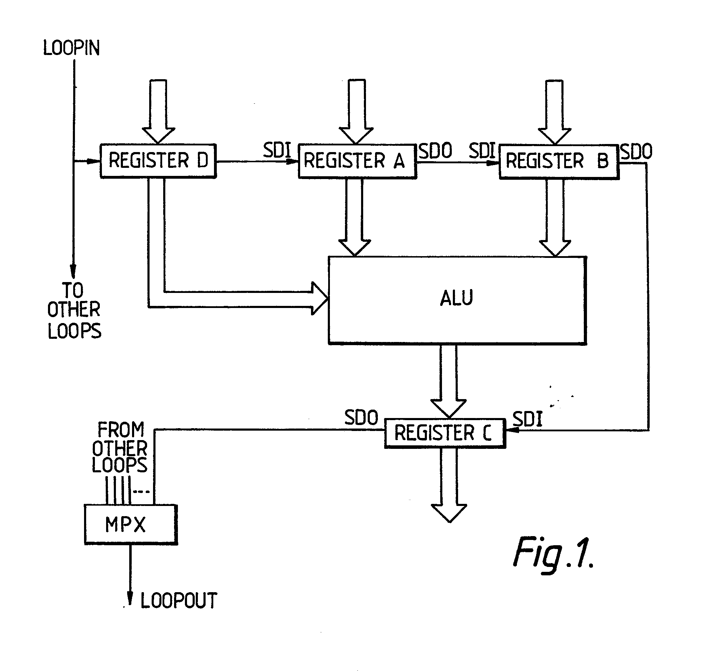

Referring to Figure 1, this shows a portion of a very large scale integrated circuit (VLSI) chip. The chip includes an arithmetic and logic unit ALU, having input registers A and B, an output register C, and a control register D which controls the mode of operation of the ALU.

In the normal operation, each of the registers A-D acts as a conventional buffer register with parallel input and output. As will be described, each register can also be operated in a shift mode in which it acts as a shift register, allowing data to be shifted into it by way of a serial data input SDI and shifted out by way of a serial data output SDO. As shown, the registers A-D are connected in series by means of these serial input and output terminals, to form a serial shift path or loop, extending between a loop data input pin LOOPIN and a loop data output pin LOOPOUT. The chip also contains other similar loops (not shown) connected in parallel with the loop shown, by means of a multiplexer MPX which can select the output of any one of the loops for connection to the LOOPOUT pin.

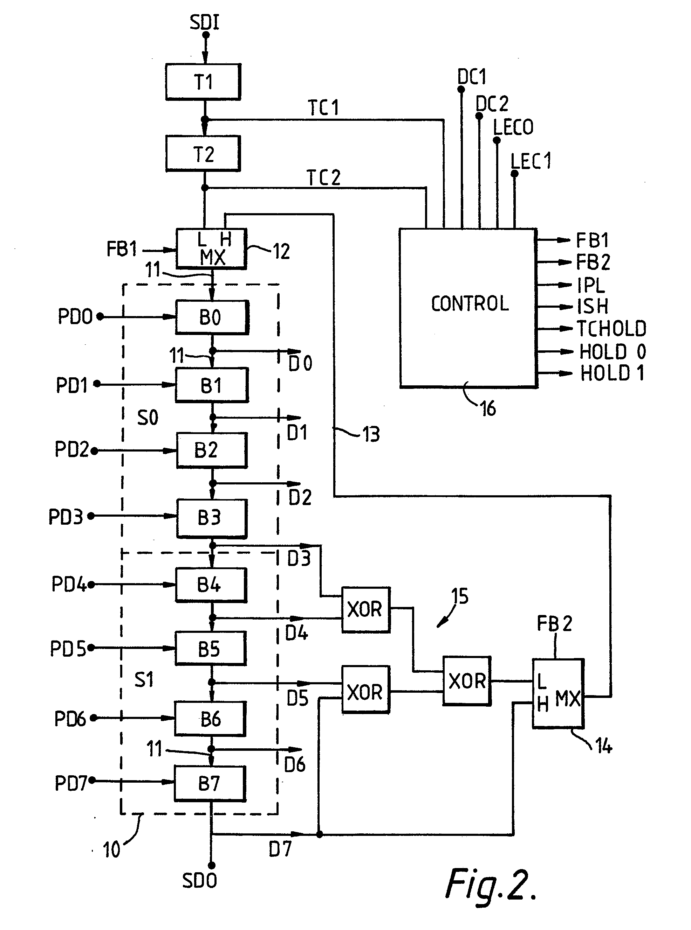

Referring to Figure 2, this shows one of the registers in more detail. The register 10 includes eight bit cells B0-B7 arranged in two sections S0, S1 each section containing four cells. The cells have respective data inputs PD0-PD7 and data outputs D0-D7 for parallel input and output of data. These parallel inputs and outputs are the normal inputs and outputs of the register when it is serving its normal function as part of the data-flow on the chip, and are connected as shown in Figure 1. In this normal mode of operation, the sections are controlled individually by load enable control signals LEC0, LEC1 which enable data to be loaded in parallel into the respective sections S0, S1 from the inputs PD0-PD3 and PD4-PD7.

Each cell also has a serial data input 11. The output of each cell B0-B6 is fed to the serial input 11 of the next cell, so as to connect all the cells B0-B7 together in series as a shift register. The output from the last bit cell B7 is connected to the serial data output SDO of the register. The register also contains two test control bit cells T1, T2. These are connected in series between the serial data input SDI of the register and the serial input 11 of bit cell B0, by way of a multiplexer 12.

The multiplexer 12 is controlled by a signal FB1. When FB1 is low, the multiplexer selects the output of bit cell T2. This causes the cells T1, T2, B0-B7 all to be connected together as a serial shift register between the terminals SDI and SDO. When FB1 is high, the multiplexer 12 selects a feedback path 13. This path comes from a further multiplexer 14, controlled by a signal FB2.

When FB2 is low, the multiplexer 14 selects the output of an exclusive -OR gate tree 15, and when FB2 is high, it selects the output of the last bit cell B7. The exclusive -OR gates 15 are connected to the outputs of bit cells B3, B4, B5 and B7 as shown, so as to form the exclusive -OR function (modulo - 2 sum) of these outputs.

The register has a control circuit 16 which receives the following input signals:

(a)     Mode control signals DC1, DC2. These are common to all the registers A-D in the loop.

(b)     Mode control signals TC1, TC2 from the test control bit cells T1, T2 of the register.

(c)     The load enable control signals LEC0, LEC1.

The control circuit 16 produces the following circuit signals:

(a)     The signals FB1, FB2 which control the multiplexers 12,14.

(b)     Signals IPL and ISH which are fed in common to all the bit cells B0-B7.

(c)     A signal TCHOLD which is fed to both the test control bit cells T1, T2.

(d)     Signals HOLD0 and HOLD1 which are fed respectively to sections S0 and S1.

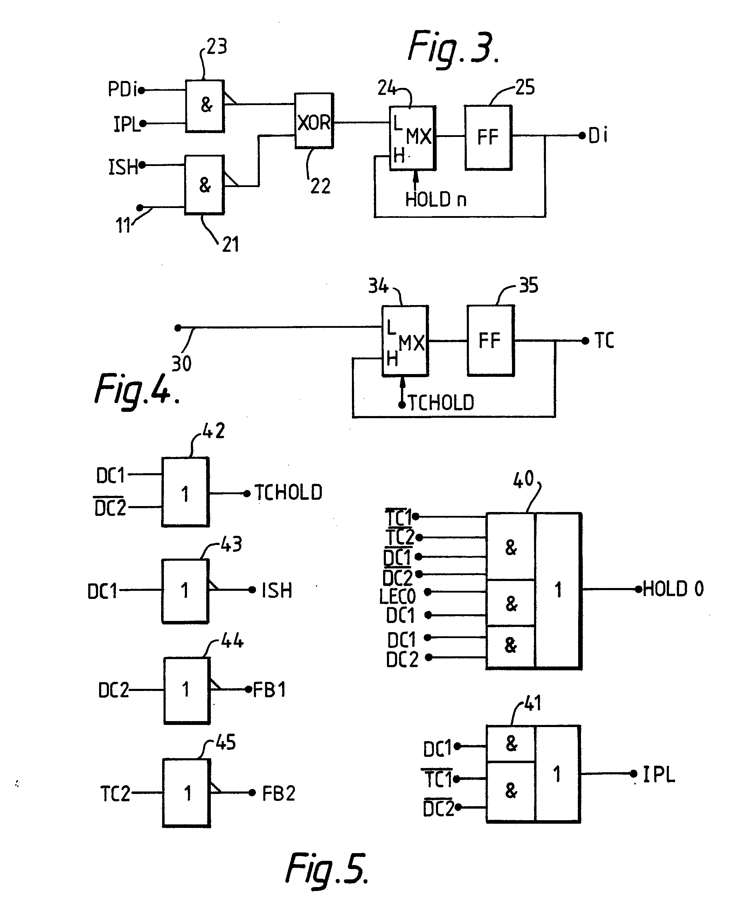

Referring now to Figure 3, this shows one of the bit cells Bi (where i = 0,1---7) in section Sn (where n = 0 or 1).

The serial data input 11 of the cell is connected to a NAND gate 21, controlled by the signal ISH. The output of this gate is fed to one input of an exclusive -OR gate 22, the other input of which is connected to the output of a NAND gate 23. The gate 23 receives the parallel data input PDi for the cell, and is controlled by the signal IPL.

Thus, when ISH is high and IPL is low, the output of gate 22 is equal to the data received at the serial input 11. When ISH is low and IPL high, the output of gate 22 is equal to the parallel data bit PDi. If both ISH and IPL are high, the output of the gate 22 is the exclusive -OR of the serial and parallel data inputs.

The output of the gate 23 is connected to one input of a multiplexer 24, the output of which is fed to the data input of a flip-flop (bistable circuit) 25. The output of the flip-flop is connected to the other input of the multiplexer 24, and also to the data output Di of the cell.

The multiplexer 24 is controlled by the signal HOLDn. When HOLDn is high, the multiplexer selects the output of the flip-flop 25, causing its current contents to be fed back to its input. Thus, the flip-flop is held frozen in its current state, regardless of the condition of its input data signals. When HOLDn is low, the multiplexer 24 selects the output of the exclusive -OR gate 22, and this allows either the serial input data, the parallel input data, or their exclusive -OR function to be clocked into the flip-flop 25.

The flip-flop 25 is a master-slave flip-flop controlled by a two-phase clock. Such flip-flops are well known and so it is not necessary to describe it in detail.

Referring now to Figure 4, this shows one of the test control bit cells T1, T2. The cell consists of a multiplexer 34 and flip-flop 35 connected in a similar manner to those in Figure 3. The multiplexer 34 is controlled by the signal TCHOLD. When TCHOLD is low, the multiplexer selects the serial input path 30 of the cell, allowing data to be shifted serially into the flip-flop 35. When TCHOLD is high, the multiplexer selects the output of the flip-flop, thereby causing the current state of the flip-flop to be frozen.

OPERATION

The register has seven modes of operation, specified by the control signals DC1, DC2, TC1 and TC2 as follows:

| DC1 | DC2 | TC1 | TC2 | Mode |
|-----|-----|-----|-----|------|
| H | H | - | - | CHIP HOLD |
| L | H | - | - | SHIFT |
| H | L | - | - | USER |
| L | L | L | L | TEST HOLD |
| L | L | L | H | TEST ANALYSE |
| L | L | H | L | TEST SLIDE |
| L | L | H | H | TEST GENERATE |

In the CHIP HOLD mode, the signals HOLD0, HOLD1, and TCHOLD are held high. Thus, the contents of all the bit cells B0-B7 and both the test control bit cells T1, T2 are frozen, and cannot be shifted or overwritten.

In the SHIFT mode, the signals HOLD0, HOLD1 and TCHOLD are held low, ISH is held high, and IPL is held low. Thus, in this mode, data is shifted along the serial shift path through all the cells T1, T2, B0-B7, between the terminals SDI and SDO. This mode can be used to set the test control bit cells T1, T2 to any desired value, and also to load test data into the bit cells B0-B7 or to read test results from those cells.

The USER mode is the normal mode of operation, when the register is serving its normal function as a parallel input/output register. In this mode, IPL is held high, ISH is held low, and the signals HOLDn are controlled directly by the load enable control signals LECn. Thus, when LECn is high, HOLDn is also high, and this causes the contents of the bit cells in the corresponding section Sn to be frozen. When LECn is low, HOLDn is also low, and this allows data to be loaded in parallel into the corresponding section Sn from the data inputs PD0-3 or PD4-7. TCHOLD is always held high in this mode and hence the contents of the test control bit cells Tl, T2 are frozen.

In the TEST HOLD mode, the signals HOLD0, HOLD1 and TCHOLD are all held high, so as to freeze the contents of all the bit cells B0-B7, T1 and T2.

In the TEST SLIDE mode, HOLD0, HOLD1 are set low, TCHOLD is high, ISH is high and IPL is low. This allows data to be shifted serially through the bit cells B0-B7 but not through the test control bit cells Tl, T2. Also, FB1 and FB2 are both held high, so that the multiplexers 12, 14 are switched to select the serial output from the last stage B7 as the serial input to B0. Hence, in this mode, the register is connected as a circular shift register, allowing its contents to be rotated. This mode is useful for producing sequences of sliding test patterns. For example, if the register is initially loaded with the pattern 0000 0001, the TEST SLIDE mode can be used to rotate this pattern so that the "1" appears successively in each bit position.

In the TEST GENERATE mode, the signals HOLD0, HOLD1 TCHOLD, ISH, IPL, and FB1 all have the same values as in the TEST SLIDE mode. However, in this case, FB2 is held low. The multiplexers 12, 14 are therefore now set to select the output of the exclusive -OR gates 15 as the serial input to the bit cell 80. Hence, in this mode, the register acts as a feedback shift register, for generating sequences of pseudo-random numbers, for use as test patterns.

In the TEST ANALYSE mode, the signals HOLD0, HOLD1, TCHOLD, ISH, FB1 and FB2 are the same as in the TEST GENERATE mode. However, in this case, IPL is held high. Thus, the input parallel data PD0-PD7 is combined in the exclusive -OR gates 22 with the shifting data within the register. In this mode, therefore, the register acts as a signature analyser, generating a digital signature from a sequence of parallel inputs. This signature can then be read out, using the SHIFT mode, and used for diagnostic purposes to detect and identify faults in the chip.

CONTROL CIRCUIT

Referring now to Figure 5, this shows the control circuit 16 in detail.

The signal HOLD0 is produced by an AND/OR gate combination 40 as shown. HOLD1 is produced by a similar logic combination not shown.

IPL is produced by an AND/OR gate combination 41. TCHOLD is produced by an OR gate 42. ISH, FB1 and FB2 are produced by inverters 43, 44 and 45.

CONCLUSION

It can be seen that the TEST SLIDE mode provides the capability for producing circularly shifting test patterns in the register. These patterns are fed by way of the output lines D0-D7 to other circuits on the chip, as test inputs. For example, in normal operation the register B0-B7 may serve as in input register for a PLA, the lines D0-D7 being connected to the bit lines of the array. In the circuit shown in Figure 1, for example, the arithmetic and logic unit ALU may be formed by a PLA, with input registers A, B and D. The TEST SLIDE mode can then be used to put a sliding "1" or "0" test pattern on the bit lines so as to enable each bit line individually. This greatly facilitates testing of the PLA.

0196152

The arrangement described above may be modified by including an exclusive -OR gate in the feedback path between the output D7 and the input of the multiplexer 14. This gate can be controlled so that it either passes the feedback signal without modification or acts as an inverter. In the latter case, the sliding test pattern is inverted in alternate cycles through the register. This allows further useful sequences of test patterns to be produced.

CLAIMS:-

1.      A digital integrated circuit including at least one register (10) which is operable in a first mode in which it acts as a parallel input/output register, and in a second mode in which it acts as a pseudo-random number generator for producing test patterns for the circuit, characterised in that the register is also operable in a third mode in which it acts as a circular shift register for producing circularly shifting test patterns.

2.      A circuit according to claim 1 including a programmable logic array having said register (10) as an input register.

3.      A circuit according to claim 1 or 2 wherein said register is one of a plurality of registers (A-D) each of which is operable in any one of the three modes specified in claim 1.

4.      A circuit according to claim 3, having a normal operating state in which all the registers are in the first mode, and a test state in which each register is independently operable in the second or third mode.

5.      A circuit according to claim 4 wherein, in the test state, each register is alternatively operable in a further mode in which it acts as a digital signature analyzer.

6.      A circuit according to any one of claims 3, 4 or 5, having a further state in which all the registers (A-D) are connected together in series to form a serial shift path between a pair of external terminals.

7.      A circuit according to any preceding claim, including an exclusive-OR network (15) connected to the outputs of selected stages of the register (10), and a multiplexer (14) for selecting either the output of the exclusive-OR network (15) or the output of the last stage (B7) of the register, for feeding back to the input of the first stage (B0) of the register.

8.      A circuit according to claim 7 including an inverter circuit for selectively inverting the output of said multiplexer (14).

9.      A method of operating a circuit according to any preceding claim comprising the steps of loading into the register (10) a bit pattern consisting of a single bit of one binary value, the other bits all being of the other binary value, and then operating the register in the third mode.

LOOPIN

REGISTER D — SDI → REGISTER A — SDO — SDI → REGISTER B — SDO

TO
OTHER
LOOPS

ALU

SDO — REGISTER C — SDI

FROM
OTHER
LOOPS

MPX

LOOPOUT

*Fig.1.*

0196152

2/3

Fig.2.

Fig.3.

Fig.4.

Fig.5.